**Europäisches Patentamt**

(19) **European Patent Office**

**Office européen des brevets**

(11) Veröffentlichungsnummer: **0 036 435**
**B1**

(12) **EUROPÄISCHE PATENTSCHRIFT**

(45) Veröffentlichungstag der Patentschrift:
**01.12.82**

(51) Int. Cl.³: **C 04 B 39/02,** B 32 B 31/08,
H 05 K 3/46

(21) Anmeldenummer: **80101572.8**

(22) Anmeldetag: **25.03.80**

(54) **Verfahren zur Herstellung von keramischen Mehrschichtgehäusen.**

(43) Veröffentlichungstag der Anmeldung:
**30.09.81 Patentblatt 81/39**

(45) Bekanntmachung des Hinweises auf die Patenterteilung:
**01.12.82 Patentblatt 82/48**

(84) Benannte Vertragsstaaten:
**AT BE CH DE FR GB IT LU NL SE**

(56) Entgegenhaltungen:
**WO-A-80/00013**
**CH-A-593 875**
**DD-A-115 105**

(73) Patentinhaber: **Rosenthal Technik AG,**
**Postfach 1508 Wittelsbacherstrasse 49,**
**D-8672 Selb/Bayern (DE)**

(72) Erfinder: **Krauth, Axel, Dr. Dipl.-Ing.,**
**Georg-Ritter-Strasse 1, D-8672 Selb (DE)**
Erfinder: **Ludwig, Hans, Sommermühlweg 39,**
**D-8672 Selb (DE)**
Erfinder: **Plechschmidt, Friedrich, Wunsiedler**
**Strasse 26, D-8671 Kirchenlamitz (DE)**
Erfinder: **Schelter, Heinrich, Ing. grad,**
**Unterweissenbach 75, D-8672 Selb (DE)**

(74) Vertreter: **Dost, Wolfgang, Dr. et al, Patent- u.**
**Rechtsanwälte Pagenberg-Dost-Altenburg Galileiplatz 1,**
**D-8000 München 80 (DE)**

## Verfahren zur Herstellung von keramischen Mehrschichtgehäusen

Die Herstellung keramischer Mehrschichtgehäuse erfolgt aus keramischen Schlickern, die wiederum aus einem keramischen Rohstoff sowie organischen Binde- und Hilfsmitteln bestehen und aus denen keramische Folien hergestellt werden, die man im Grünzustand mit Metallpasten bedruckt, durch Stanzen die erforderlichen Durchbrüche (Fenster) anbringt, und dann mehrere Folienabschnitte vor dem Brennen zu einem Laminat vereinigt.

Das Laminieren der übereinandergelegten und genau positionierten Folienabschnitte erfolgt durch Kalt- oder Heisspressen. Ein solches Verfahren ist aus der DE-B 23 57 625 bekannt.

Ein wesentlicher Nachteil der bekannten Verfahren besteht darin, dass die Herstellung der Mehrschichtgehäuse diskontinuierlich erfolgt. Die Automationsmöglichkeiten sind durch die Laminierpressen beschränkt, deren Einsatz darüber hinaus zeitaufwendig ist.

Eine Aufgabe der Erfindung besteht somit darin, ein verbessertes Verfahren zur Herstellung von keramischen Mehrschichtgehäusen zur Verfügung zu stellen, bei dem der Laminiervorgang kontinuierlich erfolgt.

Gegenstand der Erfindung ist somit ein Verfahren zur Herstellung keramischer Mehrschichtgehäuse zur Aufnahme elektronischer Schaltungen, wobei mehrere metallisierte und mit Durchbrechungen versehene Keramikfolien im Grünzustand durch Pressen laminiert und dann einem Sintervorgang unterworfen werden, das dadurch gekennzeichnet ist, dass man das Laminieren der grünen Keramikfolien kontinuierlich durch Walzen vornimmt.

Das Verfahren der Erfindung ermöglicht eine weitgehende Automatisierung, da die nach der Herstellung der Einzelfolien bisher notwendigen Detailschritte, wie Stanzen, Positionieren und Laminieren, in einem kontinuierlichen Arbeitsgang durchgeführt werden können.

Nach dem Verfahren der Erfindung erhält man Laminate mit weniger Lufteinschlüssen und sehr guter Kontaktflächenauflage. Demgemäss sind die Mehrschichtgehäuse gut vakuumdicht, und die fertigen Bauelemente besitzen ausgezeichnete Werte für die Heliumleckrate.

Nach dem Verfahren der Erfindung werden die einzelnen Keramikfolien vor dem Laminieren nicht zu Karten zerschnitten, die dann zu Kartensätzen aufeinandergestapelt werden, sondern die Folien werden in Bahnform dem Laminiervorgang durch Walzen unterworfen, und erst danach erfolgt gegebenenfalls das Ablängen und Stanzen der Verbundbahn für den Brennvorgang.

Die Zufuhr der Einzelfolien für den Laminiervorgang erfolgt vorzugsweise von der Rolle. Es ist zwar auch möglich, die Herstellung der Einzelfolien so zu steuern, dass sie ohne Zwischenlagerung auf Rolle direkt dem Laminiervorgang unterworfen werden. Diese Arbeitsweise verlangt jedoch mit zunehmender Folienzahl einen erheblichen Aufwand in der Abstimmung der Herstellungsbedingungen, so dass die Arbeitsweise von der Rolle bevorzugt ist.

In einer bevorzugten Ausführungsform des Verfahrens der Erfindung wird das Walzen mittels zweier gegenüberliegender Walzen, oder mittels mehrerer jeweils gegenüberliegender Walzenpaare durchgeführt. Hierdurch werden während des Laminiervorgangs relative Verschiebungen der Folien zueinander vermieden. Nach Massgabe der Schichtdicken und der Anzahl der Einzelfolien kann man den Keramikfolienbahn-Stapel jedoch auch durch anders angeordnete Walzen, etwa nach Art eines Walzenstuhls oder eines Kalanders, führen.

In einer weiteren bevorzugten Ausführungsform sind das oder die Walzenpaare synchron angetrieben, um eventuelle Beeinträchtigungen durch zu grosse Scherspannungen zu vermeiden.

Der Laminiervorgang kann unter Verwendung eines horizontalen ebenen Tisches erfolgen, wobei das Walzenpaar (und gegebenenfalls jedes weitere Walzenpaar) vorzugsweise so angeordnet ist, dass sich der Walzenspalt in der Tischebene und senkrecht zur Laufrichtung der zusammengelegten Keramikfolienbahnen befindet. Anstelle des Tisches kann man auch eine Walzenstrasse verwenden.

Die übereinanderliegenden Keramikfolienbahnen werden hierbei entweder über den Tisch gezogen, wobei vorzugsweise dem Schlicker zur Erzielung besserer Gleiteigenschaften Trenn- bzw. Gleitmittel zugesetzt worden sind, oder man transportiert den Folienbahnstapel auf einem Stahlband, das mit durch den Walzenspalt hindurch läuft.

Diese Stahlbandabdeckung des Folienbahnstapels kann auch beidseitig erfolgen. Bei besonders empfindlichen Schlickerrezepturen kann durch Verwendung der Stahlbänder eine Verbesserung der Dickenkonstanz bzw. die Vermeidung einer Welligkeit erreicht werden.

Erfindungsgemäss erfolgt das Laminieren bei Drücken von 0,2 bis 25 kp/cm². Im Einzelfall richtet sich der angewendete Druck nach den Eigenschaften der Folie, wie Flexibilität und Schichtdicke.

Hierbei ist insbesondere von Bedeutung, dass die Walzen unter Federdruck stehen und nicht starr gelagert sind. Auch kann es bei der Herstellung bestimmter Mehrschichtgehäuse wichtig sein, dass die Walzenoberfläche strukturiert ist. Die Profilgebung der Walzen richtet sich hierbei nach den Folienausnehmungen bzw. den Fensterabmessungen. Bei Verwendung von Profilwalzen arbeitet man zweckmässig mit optischer Vorschubsteuerung.

In einer weiteren bevorzugten Ausführungsform führt man den Laminiervorgang mit unbeheizten Walzen durch. Im allgemeinen tritt bei der Durchführung des Verfahrens keine grössere Wärmeentwicklung auf. Sollte es trotzdem, u.U.

auch klimatisch bedingt, zu Temperaturen von über 50°C oder sogar über 60°C kommen, wird vorzugsweise eine Temperaturabsenkung herbeigeführt, z.B. durch Kühlung der Laminierwalzen. Bei zu hohen Temperaturen kann es nach Massgabe der angewendeten Schlickerrezepturen und der Geometrie zu unerwünschten Fliesserscheinungen kommen.

In einer weiteren bevorzugten Ausführungsform bringt man vor dem Zusammenführen der Keramikfolienbahnen für den Laminiervorgang einen Filler und/oder ein Spray als Laminierhilfsmittel auf. Hierbei handelt es sich im ersten Fall um ein Laminierhilfsmittel mit ähnlicher Rezeptur wie die zum Aufbringen der Leiterbahnmuster verwendeten Metallsiebdruckpasten, wobei jedoch im Filler der Metallanteil durch Keramik ersetzt ist. Diese Filler werden in sehr dünner Schicht durch Aufdrucken aufgebracht. Das Laminierspray als Klebemittel auf organischer Basis wird dagegen durch Aufsprühen aufgebracht. Die Anwendung von Laminierhilfsmitteln bringt mehrere Vorteile mit sich. Zum einen werden hierdurch niedrigere Drücke beim Laminiervorgang ermöglicht. Weiterhin erreicht man eine gute Standfestigkeit der Stege, und schliesslich wirkt sich die Verwendung der Laminierhilfsmittel vorteilhaft bei der Vermeidung von Laminierfehlern aus.

Vorzugsweise werden die Folienbahnen an beiden Aussenkanten mit Positionierungsstellen versehen, die entweder mechanisch, z.B. durch Stanzen von Löchern für den Eingriff von Positionierstiften, oder durch optisch erkennbare Bilder vorgesehen werden, und die erst nach beendetem Laminiervorgang entfernt werden. Positionierstifte können sich an seitlichen Fördermitteln befinden, deren Vorschub durch den Walzenvorschub geregelt wird.

Die erfindungsgemäss erzielten Laminiergeschwindigkeiten hängen ab von den Fliesseigenschaften der Folie und den Positioniereinrichtungen. Hierbei wird die obere Grenze der Laufgeschwindigkeit in erster Linie davon bestimmt, dass Verformungen der Folien und der Ausstanzungen vermieden werden müssen. In der Praxis beträgt die Laminiergeschwindigkeit im allgemeinen 0,2 bis 2,5 m/min.

Man kann den Laminiervorgang so durchführen, dass sämtliche Keramikfolienbahnen in einem einzigen Arbeitsgang zusammenlaminiert werden. Man kann jedoch auch stufenweise vorgehen, indem z.B. bei Dreischichtgehäusen zunächst die Bahnen A und B und dann die Verbundbahn AB mit der Bahn C laminiert werden. Die Wahl der speziellen Arbeitsweise hängt hierbei z.B. auch von der gewünschten späteren Seitenmetallisierung bzw. Gehäuseform ab.

Das Verfahren der Erfindung wird unter Verwendung üblicher Keramikfolien durchgeführt. Bevorzugt werden Keramikfolien, bei denen die Leiterbahnen in die Keramikmasse integriert sind. Die Herstellung solcher Keramik-Einzelfolien ist in der DE-B-23 57 625 und der US-A-3 870 776 beschrieben, auf die hier vollinhaltlich Bezug genommen wird.

Das Aufdrucken der Leiterbahnen und anderen metallisierten Figuren (z.B. pads) erfolgt vorzugsweise nach üblichen Siebdruckverfahren in Dickfilmtechnik. Hierbei finden übliche Wolframpasten oder Molybdänpasten Verwendung.

Bei Verwendung von Keramikfolien mit integrierten Leiterbahnen erfolgt zunächst der Druck der Leiterbahnen auf eine Trägerfolie, die nach dem Überdecken der Leiterbahn mit Keramikmasse wieder entfernt wird.

Als Trägerfolien sind hierbei sowohl Kunststoff- als auch Metallbänder geeignet, wobei Stahlbänder eine bessere Festigkeit und Masshaltegenauigkeit besitzen.

Die getrockneten und gegebenenfalls mit Durchbrechungen (Fenstern) sowie Positionierungsstellen an den Seitenkanten versehenen Keramikfolienbahnen werden dann vorzugsweise auf Rolle genommen.

Für die Herstellung der erfindungsgemäss geeigneten Keramikfolienbahnen sind übliche Schlicker geeignet. Beispiele sind in der US-A-2 966 719 und der DE-B-23 57 625 beschrieben.

Der Schlicker besteht aus keramischem Rohstoff, organischem Bindemittel, Dispergier- oder Verdünnungsmittel und gegebenenfalls Weichmachern und sonstigen Hilfsmitteln.

Bevorzugt werden Schlicker, die 75 bis 97 Prozent Tonerde ($Al_2O_3$), vorzugsweise 85 bis 96 Prozent Tonerde, enthalten, wobei der Rest aus Sinterungshilfsmitteln und oxidischen Farbkörpern besteht. Als Sinterungshilfsmittel kommen z.B. Talkum bzw. Speckstein, Magnesiumoxid, Zirkonoxid, Wollastonit, Quarzmehl, Kaolin oder Zirkonsilikat in Frage.

Das organische Bindemittel unterliegt an sich keiner besonderen Beschränkung, sofern eine gute Bindung gewährleistet ist und der Folie, gegebenenfalls in Kombination mit dem Weichmacher, die erforderliche Zähigkeit und Masshaltegenauigkeit verliehen wird. Besonders gut bewährt haben sich Polyvinylacetate und Polyvinylbutyral.

Als Dispergier- oder Verdünnungsmittel dienen organische Lösungsmittel. Beispiele für geeignete organische Lösungsmittel sind Äthanol, Toluol, Trichloräthylen, usw.

Zur Erzielung guter Folieneigenschaften beträgt die Viskosität des Schlickers vorzugsweise 4000 bis 7000 cP, bei einem Gehalt an keramischem Rohstoff von 55 bis 90 Prozent, vorzugsweise um etwa 70 Prozent.

Ein besonders bevorzugtes Beispiel für eine schwarze Keramik ist nachfolgend angegeben. Hierbei findet als Farbkörper eine Kombination aus Chromoxid und Titandioxid Verwendung. Andere geeignete Farbkörper sind Eisenoxid, Mangancarbonat und Ammoniumparawolframat. Sofern eine weisse Keramik gewünscht wird, bleiben die Farbkörper weg.

Zur Herstellung des Schlickers wird der keramische Rohstoff in solcher Menge in dem Binde-und Dispergiermittel gelöst, dass die Viskosität des erhaltenen Schlickers etwa 6500 cP beträgt. Der Schlicker besitzt dann einen Gehalt an keramischem Rohstoff von 59 bis 81 Gew.-%, z.B. 68 Gew.-%, bezogen auf Gesamtmasse.

| Keramischer Rohstoff Bestandteil | Gew.-% | Binde- und Hilfsmittel Bestandteil | Gew.-% |
|---|---|---|---|
| Tonerde | 90 | Toluol | 25 |
| Speckstein | 2 | Äthanol | 7 |
| Talkum | 2 | Polyvinylbutyral[a] | 7,5 |
| Wollastonit | 2 | Weichmacher[b] | 4,2 |
| Zirkonsilikat | 0,5 | Menhaden-Öl[c] | 1,5 |
| $Cr_2O_3$ | 2,8 | | |
| $TiO_2$ | 0,7 | | |

a) Verwendet wurde Butvar B 98;
b) Als Weichmacher diente ein Gemisch aus 2,7 Teilen Palatinol AH und 1,5 Teilen Ucolub S 140;
c) Hierbei handelt es sich um einen Fischtran, der als Trennmittel wirkt.

Erfindungsgemäss besonders geeignete Rahmenrezepturen für die Herstellung der Keramikfolien sind nachfolgend angegeben, wobei die Schlickerrezepturen nach Keramikrohstoff (einschliesslich Farbkörper) und Binde- und Hilfsmittel aufgeschlüsselt sind.

Keramikrohstoff, einschliesslich Farbkörper (Gew.-%)

| | allg. Bereich | bevorz. Bereich | Beispiel |
|---|---|---|---|
| $Al_2O_3$ | 75–97 | 87–95 | 91 |
| Talk | 1–5 | 1–3,5 | 2,5 |
| Wollastonit | 1–5 | 1–3 | 1,8 |
| Kaolin | 1–5 | 1–3 | 1,7 |
| $Cr_2O_3$ | 0–4 | – | – |
| $TiO_2$ | 0–3,5 | – | – |
| $WO_3$ | 0–5 | 1,8–4,0 | 3,0 |
| Summe | 100 | 100 | 100 |

Binde- und Hilfsmittel (Gew.-%), bezogen auf 100 Gew.-% Keramikrohstoff (einschliesslich Farbkörper)

| | allg. Bereich | bevorz. Bereich | Beispiel |
|---|---|---|---|
| Bindemittel | 3–11 | 3,5–7,5 | 5,0 |
| Weichmacher | 2,5–8 | 3,0–6,0 | 3,5 |
| Lösungsmittel | 25–50 | 27–40,0 | 29,0 |

Im folgenden ist die Erfindung anhand der Zeichnungen erläutert. Es zeigen:

Fig. 1 in Form eines Fliessschemas die Herstellung von grünen Einzelfolien für die Durchführung des Verfahrens der Erfindung,

Fig. 2 einen detaillierten Teilausschnitt von Fig. 1,

Fig. 3 die Durchführung des Laminiervorgangs nach dem Verfahren der Erfindung, und

Fig. 4 ein Blockschema, das den gesamten Herstellungsvorgang vom Rohstoff über die Herstellung der Grünfolien und das Laminieren bis zum Brennen der Mehrschichtgehäuse veranschaulicht.

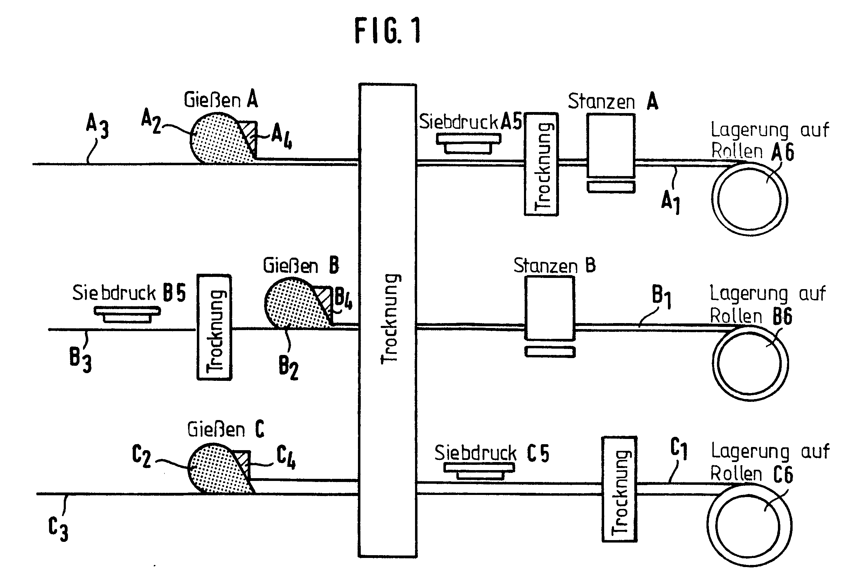

In Fig. 1 werden Folien A1 und C1 durch übliches Verziehen von Schlicker A2, C2 auf einem Stahlband A3, C3 hergestellt. Die Schlickeraufgabe erfolgt mittels eines Druckbehälters (nicht dargestellt) über einen Giessschuh A4, C4, der über dem Stahlband bewegungsfrei gelagert ist. Die Folienstärke (von 0,2 bis 1,5 mm) wird durch eine einstellbare Spalthöhe am Giessschuh bestimmt. Für gleichbleibendes Schlickerniveau im Giessschuh sorgt eine Fotozelle (nicht dargestellt), die über ein Druckluftsystem die Schlickerzugabe steuert. Die Folien A1, C1 werden später von dem Stahlband A3, C3 wieder abgezogen (nicht dargestellt).

Die Ablösbarkeit der Folie wird durch Vorbehandeln des Stahlbandes A3, C3 mit einem Trennmittel (z.B. Fischöl) erzielt. Man arbeitet mit Bandgeschwindigkeiten von 10 cm/min bis 1 m/min, z.B. mit 20 cm/min, bei Bandlängen von 15 bis 25 m. Zur Verdampfung von Lösungsmittel ist das abgedeckte Band mit einem Abluftsystem und einer Heizung (Trocknung) ausgestattet. Raumluft wird über eine Heizung (nicht dargestellt) angesaugt, über das Band geführt und schliesslich abgesaugt. Man arbeitet im Temperaturbereich von 40 bis 150°C.

Am Bandende, nach Abschluss der Trocknung, wird die Folie auf die gewünschte Breite geschnitten. Nach dem Ablösen der Folie vom Trägerband erfolgt Anbringung von Positionierlöchern (Folien A1, B1), Siebdrucken (Folien A1, C1) Trocknen durch Trocknungskanal (Folien A1, C1), Stanzen eines Fensters (Folie A1) und Lagerung auf Rollen A6, C6. Bei nicht integrierten Leiterbahnen kann das Stanzen auch vor dem Siebdrucken erfolgen.

Ein Siebdruck A5 bei der Folie A1 dient dem Aufbringen einer Deckelmetallisierung, ein Siebdruck C5 der Folie C1 dem Aufbringen von Leiterbahnflecken (pads).

Bei der Herstellung einer Folie B1 mit integrierter Leiterbahn erfolgt zunächst Aufdrucken eines Leitungsmusters mittels Siebdruck B5 auf eine Kunststoff-Trägerfolie B3. Während des Druckvorgangs werden gleichzeitig Positioniermarkierungen (nicht dargestellt) mitgedruckt. Nach Trocknung erfolgt Aufziehen von Schlicker B2 in gleicher Weise wie bei den Folien A1, C1 beschrieben.

Nach erneuter Trocknung und Abziehen der Trägerfolie B3 erfolgt optisches Erfassen der Positioniermarkierungen und Stanzen von Registrierung und Ausnehmung bzw. Fenster. Die Folie B1 wird dann auf Rolle B6 genommen.

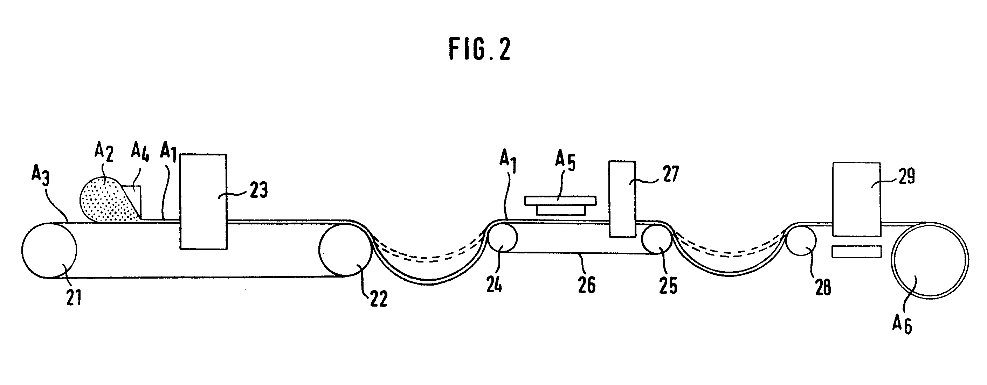

Fig. 2 zeigt einen detaillierten Teilausschnitt von Fig. 1, aus dem das Aufbringen und Ablösen der Keramikfolien von den Trägerbändern, dargestellt an der Folie A1, ersichtlich ist.

Das Stahlband A3 wird von Walzen 21, 22 mit dem gewünschten Vorschub angetrieben. Nach dem Giessen der Folie A1 erfolgt eine erste Trocknung 23. Die Ablösung der getrockneten Folie A1 vom Stahlband A3 erfolgt in Höhe der Walze 22, wobei ein mehr oder weniger grosser Druchhang der Folie (minimal = gestrichelte Linien, maximal = durchgezogene Linien) vor dem Auflaufen auf ein weiteres Trägerstahlband 26 vorgesehen ist. Das Trägerband 26 wird durch Walzen 24, 25 angetrieben.

Es erfolgt dann der Siebdruck A5, der dem Aufbringen einer Deckelmetallisierung dient, worauf sich eine weitere Trocknung 27 anschliesst. Der Siebdruck erfolgt hierbei entweder synchron, d.h. bei mitlaufender Siebdruckeinrichtung, oder bei Folienstillstand in getakteter Arbeitsweise. Der vorgeschaltete kontinuierliche Giessvorgang der Folie bleibt von der speziellen Siebdruck-Arbeitsweise unberührt.

In Höhe der Walze 25 erfolgt die Ablösung der bedruckten und getrockneten Folie A1 vom Trägerband A26, wobei ein gewisser Durchhang der Folie (minimal = gestrichelte Linien, maximal = durchgezogene Linien) vorgesehen ist. Die Folie wird dann über eine Führungswalze 28 einer Aufnahmerolle A6 zugeführt, wobei zuvor mittels einer Stanze 29 ein Fenster ausgestanzt wird.

Bei den Folien B1 und C1 erfolgt die Herstellung sinngemäss, wobei die aus Fig. 1 ersichtlichen Unterschiede zu berücksichtigen sind.

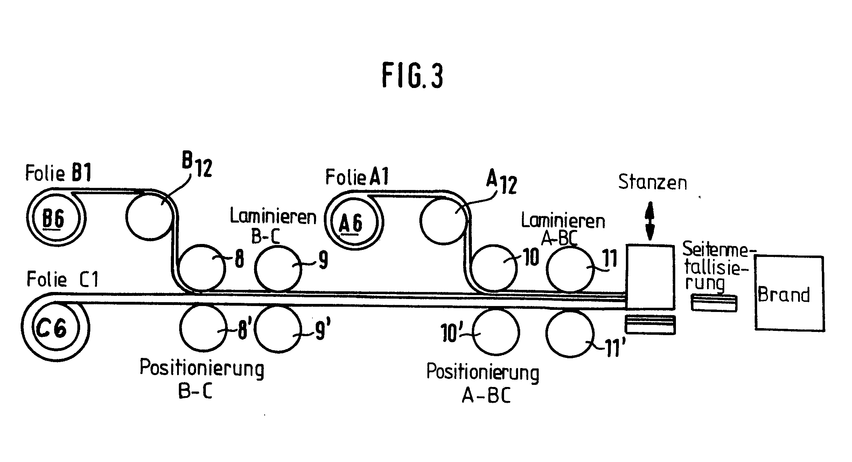

In Fig. 3 ist der Laminiervorgang der in Fig. 1 hergestellten Folien A1, B1, C1 dargestellt.

Die Folien A1, B1, C1 werden von Rollen A6, B6, C6 abgezogen. Das Laminieren erfolgt unter Verwendung von Laminierwalzenpaaren 8, 8', 9, 9'; 10, 10'; 11, 11'. Darüber hinaus sind Führungswalzen A12, B12 vorgesehen.

Die Laminierwalzen sind paarweise federnd gegeneinander gelagert, so dass Drücke von 0,2 bis 25 kp/cm² ausgeübt werden und insbesondere keine Deformation der Folien stattfindet. Das Laminieren erfolgt bei niedrigen Temperaturen, maximal 60° C.

Im vorliegenden Ausführungsbeispiel werden zunächst die Folien B1 und C1 vereinigt, worauf Laminierung der Verbundfolie B1 C1 mit der Folie A1 erfolgt. Die genaue Positionierung wird hierbei durch optische Vorpositionierung und schliesslich durch mechanische Positionierung erreicht. Letztere kann entweder durch Positionierwalzen, die mit entsprechenden Positionierstiften versehen sind oder durch ein mitlaufendes Metall- und Kunststoffband mit Positionierstiften erfolgen.

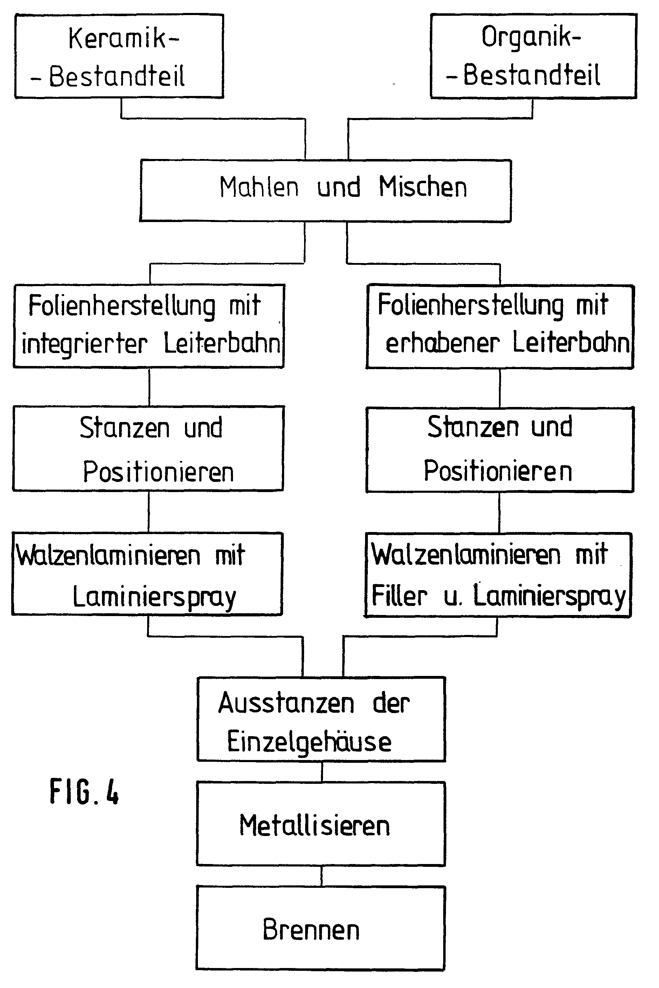

Nach Massgabe der Folienart (vgl. Fig. 4) finden als Laminierhilfsmittel Filler und/oder Laminierspray Verwendung.

Nach beendetem Laminiervorgang erfolgt Stanzen (Vereinzeln) der Gehäuse mit Hilfe der Positionierlöcher. Hieran schliesst sich eine Seitenmetallisierung und dann Brennen der Gehäuse an.

Die Seitenmetallisierung erfolgt in üblicher Weise durch Siebdruck, Tampondruck oder Tauchen. Beim Brennen finden Temperaturen von 1450 bis 1750°C, vorzugsweise 1550 bis 1700°C, Anwendung.

Das Blockschema von Fig. 4 zeigt den gesamten Herstellungsvorgang vom Rohstoff bis zum Brand der Mehrschichtgehäuse und verdeutlicht den unterschiedlichen Zweck der Anwendung von Filler und/oder Laminierspray beim Laminiervorgang.

Bei der Verwendung von Folien mit erhabenen Leiterbahnen (rechte Seite von Fig. 4) ist die Anwendung eines Fillers zum Ausgleich des durch die erhabene Leiterbahn bedingten Höhenunterschiedes zweckmässig. Demgegenüber ist bei Verwendung von Folien mit integrierter Leiterbahn (linke Seite von Fig. 4) die Verwendung eines Fillers entbehrlich.

**Patentansprüche**

1. Verfahren zur Herstellung keramischer Mehrschichtgehäuse zur Aufnahme elektronischer Schaltungen, wobei mehrere metallisierte und mit Durchbrechungen versehene Keramikfolien im Grünzustand durch Pressen laminiert und dann einem Sintervorgang unterworfen werden, dadurch gekennzeichnet, dass man das Laminieren der grünen Keramikfolien kontinuierlich durch Walzen vornimmt.

2. Verfahren nach Anspruch 1, dadurch gekennzeichnet, dass man das Walzen mittels zweier gegenüberliegender Walzen (8, 8') oder mittels mehrerer hintereinanderliegender Walzenpaare (8, 8' und 9, 9'; 10, 10' und 11, 11') durchführt.

3. Verfahren nach Anspruch 2, dadurch gekennzeichnet, dass man die Walzenpaare synchron antreibt.

4. Verfahren nach mindestens einem der Ansprüche 1 bis 3, dadurch gekennzeichnet, dass man bei Walzendrücken von 0,2 bis 25 kp/cm² laminiert.

5. Verfahren nach mindestens einem der Ansprüche 1 bis 4, dadurch gekennzeichnet, dass man das Laminieren mit unbeheizten Walzen und gegebenenfalls mit gekühlten Walzen durchführt.

6. Verfahren nach mindestens einem der Ansprüche 1 bis 5, dadurch gekennzeichnet, dass man die Keramikfolienbahnen nach dem Zusammenlegen auf einem Tisch oder einer bewegten Unterlage führt, wobei der oder die Walzenspalte der Laminierwalzen in der Tischebene und senkrecht zur Laufrichtung der Keramikfolienbahnen angeordnet sind.

7. Verfahren nach mindestens einem der Ansprüche 1 bis 6, dadurch gekennzeichnet, dass man auf die Laminierseiten der Keramikfolienbahnen vor dem Laminiervorgang einen Filler und/oder Laminierspray aufbringt.

8. Verfahren nach mindestens einem der Ansprüche 1 bis 7, dadurch gekennzeichnet, dass man den Keramikfolienbahn-Stapel mit einer ein- oder beidseitigen Stahlbandabdeckung durch den Walzenspalt laufen lässt.

9. Verfahren nach mindestens einem der Ansprüche 1 bis 8, dadurch gekennzeichnet, dass man das Laminieren von drei oder mehr Keramikfolienbahnen stufenweise durchführt.

10. Verfahren nach mindestens einem der Ansprüche 1 bis 9, dadurch gekennzeichnet, dass man das Laminieren mit Walzengeschwindigkeiten von 0,2 bis 2,5 m/min durchführt.

## Claims

1. A method of manufacturing ceramic multilayer casings for accommodating electronic circuits, wherein several metallized ceramic sheets having recesses are laminated in the green form by pressing and then subjected to sintering, characterized in that the laminating of the green ceramic sheets is carried out continuously by rolling.

2. A method according to claim 1, characterized in that the rolling is carried out by means of opposite rolls (8, 8') or by means of several pairs of rolls (8, 8' and 9, 9'; 10, 10' and 11, 11') arranged in series.

3. A method according to claim 2, characterized in that the pairs of rolls are driven by synchronous drive.

4. A method according to at least one of claims 1 to 3, characterized by laminating at roll pressures from 0.2 to 25 kp/cm².

5. A method according to at least one of claims 1 to 4, characterized in that the laminating is carried out with unheated rolls and, optionally, with cooled rolls.

6. A method according to at least one of claims 1 to 5, characterized by guiding the ceramic sheetings, after putting one sheeting upon the other, on a table or a moving support, wherein the roll nip or roll nips of the laminating rolls are aligned in the plane of the table and perpendicular to the running direction of the ceramic sheetings.

7. A method according to at least one of claims 1 to 6, characterized by applying onto the sides to be laminated of the ceramic sheetings before the laminating step a filler and/or laminating spray.

8. A method according to at least one of claims 1 to 7, characterized by feeding the ceramic sheeting stack with a steel band-covering on one or both sides through the roll nip.

9. A method according to at least one of claims 1 to 8, characterized in that the laminating of three or more ceramic sheetings is carried out step-wise.

10. A method according to at least one of claims 1 to 9, characterized in that the laminating is carried out by utilizing roll speeds from 0.2 to 2.5 m/min.

## Revendications

1. Procédé de fabrication de boîtiers multicouches en céramique pour l'installation de circuits électroniques, procédé dans lequel plusieurs feuilles de céramique métallisées et munies de découpures sont laminées par pressage et soumises ensuite à une étape de frittage, caractérisé en ce que l'on effectue le laminage des feuilles vertes de céramique en continu au moyen de cylindres.

3. Procédé selon la revendication 1, caractérisé en ce que l'on effectue le laminage au moyen de deux cylindres opposés (8, 8') ou au moyen de plusieurs paires de cylindres situés les uns derrière les autres (8, 8' et 9, 9'; 10, 10' et 11, 11').

3. Procédé selon la revendication 3, caractérisé en ce que l'on actionne les paires de cylindres de façon synchrone.

4. Procédé selon au moins l'une des revendications 1 à 3, caractérisé en ce que l'on lamine avec des pressions de cylindres 0,2 à 25 kp/cm².

5. Procédé selon une au moins des revendications 1 à 4, caractérisé en ce que l'on réalise le laminage avec des cylindres non chauffés et le cas échéant avec des cylindres refroidis.

6. Procédé selon l'une au moins des revendications 1 à 5, caractérisé en ce que l'on conduit les bandes de feuilles de céramique après leur réunion sur une table ou un support en mouvement, l'intervalle ou les intervalles des cylindres de laminage étant disposés dans le plan de la table et verticalement par rapport au sens de marche des bandes de feuilles en céramique.

7. Procédé selon au moins une des revendications 1 à 6, caractérisé en ce qu'on applique sur les côtés de laminage des bandes de feuilles de céramique une charge et/ou un spray de laminage avant l'opération de laminage.

8. Procédé selon l'une au moins des revendications 1 à 7, caractérisé en ce que l'on fait passer à travers l'écartement des cylindres l'empilement des feuilles continues en céramique avec recouvrement par ruban en acier sur l'un ou les deux côtés.

9. Procédé selon l'une au moins des revendications 1 à 8, caractérisé en ce que l'on réalise le laminage de trois bandes de feuilles de céramique ou davantage par étapes.

10. Procédé selon l'une au moins des revendications 1 à 9, caractérisé en ce que l'on effectue le laminage avec des vitesses de cylindres de 0,2 à 2,5 m/mn.

# FIG. 1

Gießen A

$A_3$    $A_2$    $A_4$

Siebdruck A5    Trocknung    Stanzen A

Lagerung auf Rollen A6

$A_1$

Gießen B

Siebdruck B5    Trocknung    $B_4$    Trocknung

Stanzen B

$B_3$    $B_2$

$B_1$    Lagerung auf Rollen B6

Gießen C

$C_2$    $C_4$

Siebdruck C5    $C_1$    Lagerung auf Rollen C6

$C_3$    Trocknung

0 036 435

FIG. 2

# FIG.3

Folie B1    B12

B6

Folie C1

C6

Laminieren B-C

8   9

8'   9'

Positionierung B-C

Folie A1    A12

A6

Laminieren A-BC

10   11

10'   11'

Positionierung A-BC

Stanzen

Seitenme-tallisie-rung

Brand

0 036 435

```
┌─────────────────┐                    ┌─────────────────┐
│   Keramik-      │                    │   Organik-      │
│  -Bestandteil   │                    │  -Bestandteil   │
└─────────────────┘                    └─────────────────┘
              │                              │
              └──────────────┬───────────────┘
                    ┌─────────────────────────┐
                    │   Mahlen und Mischen     │
                    └─────────────────────────┘
              ┌────────────────┴────────────────┐
┌─────────────────────────┐          ┌─────────────────────────┐
│  Folienherstellung mit  │          │  Folienherstellung mit  │
│  integrierter Leiterbahn│          │   erhabener Leiterbahn   │
└─────────────────────────┘          └─────────────────────────┘
              │                                │
┌─────────────────────────┐          ┌─────────────────────────┐
│     Stanzen und         │          │     Stanzen und         │
│     Positionieren       │          │     Positionieren       │
└─────────────────────────┘          └─────────────────────────┘
              │                                │
┌─────────────────────────┐          ┌─────────────────────────┐
│  Walzenlaminieren mit   │          │  Walzenlaminieren mit   │
│     Laminierspray       │          │  Filler u. Laminierspray│
└─────────────────────────┘          └─────────────────────────┘
              └────────────────┬───────────────┘
                    ┌─────────────────────────┐
                    │   Ausstanzen der        │
                    │    Einzelgehäuse        │
                    └─────────────────────────┘
                              │
                    ┌─────────────────────────┐
                    │      Metallisieren       │
                    └─────────────────────────┘
                              │
                    ┌─────────────────────────┐
                    │        Brennen           │
                    └─────────────────────────┘
```

FIG. 4